**Europäisches Patentamt**

**European Patent Office**

**Office européen des brevets**

(19)

(11) Veröffentlichungsnummer : **0 194 440**
**B1**

(12) **EUROPÄISCHE PATENTSCHRIFT**

(45) Veröffentlichungstag der Patentschrift :
04.05.88

(51) Int. Cl.⁴ : **G 03 C   1/68**

(21) Anmeldenummer : **86101345.6**

(22) Anmeldetag : **03.02.86**

(54) Lichtempfindliches Aufzeichnungselement.

(30) Priorität : 08.02.85 DE 3504254

(43) Veröffentlichungstag der Anmeldung :
17.09.86 Patentblatt 86/38

(45) Bekanntmachung des Hinweises auf die Patenterteilung : 04.05.88 Patentblatt 88/18

(84) Benannte Vertragsstaaten :
CH DE FR GB IT LI NL SE

(56) Entgegenhaltungen :
DE-A- 2 509 842
CHEMICAL ABSTRACTS, Band 86, Nr. 4, 24. Januar 1977, Seite 110, Nr. 18537r, Columbus, Ohio, US

(73) Patentinhaber : BASF Aktiengesellschaft
Carl-Bosch-Strasse 38
D-6700 Ludwigshafen (DE)

(72) Erfinder : Schupp, Hans, Dr.
Gartenweg 10
D-6706 Wachenheim (DE)
Erfinder : Sanner, Axel, Dr.
Lorscher Ring 2c
D-6710 Frankenthal (DE)
Erfinder : Elzer, Albert, Dr.
Pappelstrasse 4
D-6701 Otterstadt (DE)
Erfinder : Hofmann, Reiner, Dr.
Mandelbergstrasse 44
D-6730 Neustadt (DE)

## Beschreibung

Die Erfindung betrifft ein lichtempfindliches Aufzeichnungselement mit einer auf einem Träger aufgebrachten, wäßrig-alkalisch entwickelbaren, ein polymeres Bindemittel enthaltenden, photopolymerisierbaren Aufzeichnungsschicht, welches insbesondere für die Herstellung von Druckformen oder Resistmustern geeignet ist.

Die bekannten, mit wäßrig-alkalischen Entwicklerlösungen auswaschbaren, lichtempfindlichen Aufzeichnungselemente für die Herstellung von photopolymeren Druckformen oder Resistmustern enthalten auf einem dimensionsstabilen Träger, z. B. einer Kunststoff-Folie oder einem Metallblech, eine photopolymerisierbare Aufzeichnungsschicht, im allgemeinen aus einer Mischung von mindestens einem in den wäßrig-alkalischen Entwicklerlösungen löslichen oder dispergierbaren polymeren Bindemittel, mindestens einer ethylenisch ungesättigten, photopolymerisierbaren, niedermolekularen Verbindung, mindestens einem Photoinitiator sowie gegebenenfalls weiteren, die verarbeitungs- und/oder anwendungstechnischen Eigenschaften verbessernden und/oder modifizierenden Zusatz- und/oder Hilfsstoffen.

Als polymere Bindemittel für die wäßrig-alkalisch entwickelbaren photopolymerisierbaren Aufzeichnungsschichten gelangen hierbei insbesondere in den wäßrig-alkalischen Entwicklerlösungen lösliche oder zumindest dispergierbare, carboxylgruppenhaltige oder Carbonsäureanhydrid-Gruppen enthaltende Copolymerisate zur Anwendung, wie z. B. Styrol/Maleinsäureanhydrid-Copolymerisate, Styrol/Maleinsäurehalbester-Copolymerisate, Alkyl(meth)acrylat/(Meth)acrylsäure-Copolymerisate oder auch Copolymerisate aus Styrol, Alkyl(meth)acrylaten und (Meth)acrylsäure sowie gegebenenfalls weiteren Comonomeren (vgl. u.a. DE-B-20 27 467, SU-PS 190 211, DE-A-22 05 146, EP-A-49 504 oder DE-A-27 36 058). Auch wurde schon vorgeschlagen, in photopolymerisierbaren Mischungen als polymeres Bindemittel amphotere Copolymerisate einzusetzen, die aus einem basischen Comonomer, wie z. B. N-Alkyl(meth)acrylamiden oder Alkyl-aminoalkyl-(meth)acrylaten, einem sauren Comonomeren, z. B. (Meth)acrylsäure, sowie mindestens einem weiteren Comonomeren, wie z. B. Alkyl-(meth)acrylaten, Hydroxyalkyl(meth)-acrylaten, Vinylestern, Styrol oder ähnlichen, bestehen (vgl. US-PS 4 293 635).

Die bekannten, wäßrig entwickelbaren lichtempfindlichen Aufzeichnungsmaterialien sind wohl bereits für viele Anwendungszwecke brauchbar und geeignet, lassen jedoch hinsichtlich einer Reihe ihrer Eigenschaften noch zu wünschen übrig. So sind sie im photopolymerisierten Zustand häufig zu empfindlich gegenüber dem Auswasch-Medium, d.h. die Überwaschempfindlichkeit beim Entwickeln ist groß. Feine Bildelemente sind mit diesen Aufzeichnungsmaterialien vielfach nur schwer zu reproduzieren, und es müssen bei den Auswaschbedingungen sehr enge Grenzen bezüglich Auswaschzeit, Temperatur und Zusammensetzung der Entwicklerlösung eingehalten werden. Ferner kommt es bei den bekannten, wäßrig-alkalisch entwickelbaren Aufzeichnungsmaterialien leicht zu Restschicht-Bildungen bei der Entwicklung, d.h. die bei der bildmäßigen Belichtung nicht photopolymerisierten Anteile der Aufzeichnungsschicht lassen sich nicht restlos und einwandfrei vom Träger entfernen. Diese Erscheinung, die insbesondere bei Einsatz von metallischen Trägern oder Substraten für die photopolymerisierbare Aufzeichnungsschicht auftritt, ist vor allem bei der Herstellung von Resistmustern und Flachdruckplatten hinderlich.

Gemäß Chemical Abstracts, Vol. 86, 1977, Seite 110, No. 18537r, werden Lösungen von Acrylsäure/Ethylacrylat/2-Hydroxyethylmethacrylat/Methylmethacrylatcopolymeren oder α,α-Dimethylolpropionsäure/Polyethylenglykol/TDI-Copolymeren mit 1 : 1-Addukten aus 2-Hydroxyethylmethacrylat und TDI bei 80 °C behandelt und für lichthärtende Überzüge auf mit Acrylharzlack beschichteten Metalloberflächen eingesetzt. Aus den hier angegebenen Mengenverhältnissen ergibt sich, daß die Hydroxylgruppen durch Reaktion mit den Isocyanatgruppen verbraucht sind, also keine freien Hydroxylgruppen mehr vorhanden sind.

Die für Harzreliefdruckplatten der DE-A-25 09 842 einzusetzenden Copolymeren enthalten mindestens 50 Gew.% hydroxylgruppenhaltige Monomere einpolymerisiert.

Aufgabe der vorliegenden Erfindung war es, neue lichtempfindliche Aufzeichnungselemente mit einer wäßrig-alkalisch entwickelbaren photopolymerisierbaren Aufzeichnungsschicht aufzuzeigen, die für die Herstellung von photopolymeren Druckformen oder Resistmustern geeignet sind. Insbesondere war es Aufgabe der vorliegenden Erfindung, solche lichtempfindlichen Aufzeichnungselemente zu schaffen, die eine gute Entwickelbarkeit und einen möglichst großen Entwicklungsspielraum beim Auswaschen mit wäßrig-alkalischen Entwicklerlösungen aufweisen, ohne daß hierbei ihr allgemeines Eigenschaftsprofil negativ verändert wird. Die photopolymerisierbaren, wäßrig-alkalisch entwickelbaren Aufzeichnungsschichten sollen dabei insbesondere gegenüber metallischen Trägern oder Substraten gute Haftung aufweisen, ohne daß es jedoch bei der Verarbeitung zur Restschicht-Bildung in den auszuwaschenden Bereichen kommt.

Es wurde nun überraschenderweise gefunden, daß diese Aufgabe durch lichtempfindliche Aufzeichnungselemente mit einer auf einem dimensionsstabilen Träger aufgebrachten, wäßrig-alkalisch entwickelbaren photopolymerisierbaren Aufzeichnungsschicht gelöst wird, wenn die photopolymerisierbare Aufzeichnungsschicht als polymeres Bindemittel mindestens ein in Wasser unlösliches, in wäßrig-alkalischen Lösungen jedoch lösliches oder zumindest dispergierbares, filmbildendes Copolymerisat enthält, welches aus 15 bis 45 Gew.% mindestens eines Hydroxyalkyl(meth)-acrylats, 5 bis 30 Gew.% an Acrylsäure und/oder Methacrylsäure sowie 30 bis 80 Gew.% mindestens eines Alkylacrylats und/oder Alkylmethacrylats in einpolymerisierter Form besteht.

Gegenstand der Erfindung ist dementsprechend ein zur Herstellung von Druckformen oder Resistmustern geeignetes lichtempfindliches Aufzeichnungselement mit einer auf einem dimensionsstabilen Träger aufgebrachten, wäßrig-alkalisch entwickelbaren, ein polymeres Bindemittel, mindestens eine ethylenisch ungesättigte, photopolymerisierbare niedermolekulare Verbindung, mindestens einen Photopolymerisationsinitiator bzw. ein Photopolymerisationsinitiatorsystem sowie gegebenenfalls weitere Zusatz- und/oder Hilfsstoffe enthaltenden, photopolymerisierbaren Aufzeichnungsschicht, welches dadurch gekennzeichnet ist, daß in der photopolymerisierbaren Aufzeichnungsschicht als polymeres Bindemittel mindestens ein in Wasser unlösliches, in wäßrig-alkalischen Lösungen jedoch lösliches oder zumindest dispergierbares, filmbildendes Copolymerisat aus 15 bis 45 Gew.% mindestens eines Hydroxyalkylacrylats und/oder Hydroxyalkylmethacrylats, 5 bis 30 Gew.% Acrylsäure und/oder Methacrylsäure und 30 bis 80 Gew.% mindestens eines Alkylacrylats und/oder Alkylmethacrylats, wobei sich die Prozentangaben jeweils auf das Copolymerisat beziehen, enthalten ist.

Durch den erfindungsgemäßen Einsatz der speziellen Copolymerisate als polymerem Bindemittel in den photopolymerisierbaren Aufzeichnungsschichten werden lichtempfindliche Aufzeichnungselemente mit vorteilhaften, teilweise überraschend verbesserten Eigenschaften erhalten. So zeigen die lichtempfindlichen Aufzeichnungselemente nach der bildmäßigen Belichtung mit aktinischem Licht trotz eines vergleichsweise niederen Gehalts an Acrylsäure und/oder Methacrylsäure in den erfindungsgemäß einzusetzenden Copolymerisaten eine gute Entwickelbarkeit in wäßrig-alkalischen Entwicklerlösungen bei gleichzeitig guter Beständigkeit im photopolymerisierten Zustand gegenüber wäßrigen Medien, wie sie beispielsweise beim Einsatz der Druckformen oder Resistmuster zur Anwendung gelangen. Die erfindungsgemäßen lichtempfindlichen Aufzeichnungselemente weisen eine geringe Überwaschempfindlichkeit bei der Entwicklung auf, die photopolymerisierbare Aufzeichnungsschicht ist auch auf metallischen Trägern oder Substraten stabil bei gleichzeitig guter Haftung zu diesen Trägern oder Substraten, und sie erlauben die exakte und sichere Reproduktion auch von feinen Bildelementen, beispielsweise Linien von 100 μm Breite oder darunter.

Bei den erfindungsgemäß in der photopolymerisierbaren Aufzeichnungsschicht der lichtempfindlichen Aufzeichnungselemente enthaltenen polymeren Bindemitteln handelt es sich um spezielle Copolymerisate von Hydroxyalkyl-(meth)acrylaten, die in reinem Wasser unlöslich sind, in wäßrig-alkalischen Lösungen jedoch löslich oder zumindest dispergierbar sind. Bevorzugt sind die Hydroxyalkyl(meth)acrylat-Copolymerisate in wäßrig-alkalischen Lösungen mit einem pH-Wert größer als etwa 9, insbesondere im Bereich von etwa 9 bis 13 löslich oder zumindest dispergierbar, in wäßrig-alkalischen Lösungen mit pH-Werten unter etwa 9 jedoch unlöslich. Die erfindungsgemäß einzusetzenden Copolymerisate sollen filmbildend sein und haben im allgemeinen ein mittleres Molekulargewicht (Gewichtsmittel) größer etwa 10.000, vorzugsweise im Bereich von etwa 15.000 bis etwa 500.000 und insbesondere im Bereich von etwa 20.000 bis 250.000.

Die erfindungsgemäß einzusetzenden Copolymerisate sind aufgebaut aus 3 verschiedenen Arten von Comonomeren, nämlich Hydroxyalkyl-(meth)acrylaten, (Meth)acrylsäure sowie Alkyl-(meth)acrylaten. Die Copolymerisate können ein oder mehrere Comonomere der einzelnen Comonomer-Arten einpolymerisiert enthalten, d.h. sie können aus einem oder mehreren Hydroxyalkylacrylaten und/oder Hydroxyalkylmethacrylaten, Acrylsäure und/oder Methacrylsäure sowie einem oder mehreren Alkylacrylaten und/oder Alkylmethacrylaten bestehen.

Als Hydroxyalkyl-(meth)acrylate kommen insbesondere die Hydroxyalkylacrylate und/oder Hydroxyalkylmethacrylate mit 2 bis 4 C-Atomen im Hydroxyalkyl-Rest in Betracht. Vorzugsweise handelt es sich bei dieser Gruppe von Comonomeren um die Monoacrylate und Monomethacrylate von Alkandiolen, wie insbesondere Ethylenglykol, 1,2-Propandiol, 1,3-Propandiol. Als Beispiele für die Hydroxyalkyl-(meth)acrylat-Comonomeren seien genannt 2-Hydroxyethylacrylat, 2-Hydroxyethylmethacrylat, 2-Hydroxypropylacrylat, 3-Hydroxypropylacrylat, 2-Hydroxypropylmethacrylat, 3-Hydroxypropylmethacrylat sowie insbesondere Mischungen von 2-Hydroxypropyl- und 3-Hydroxypropyl(meth)acrylat. Der Anteil der in den erfindungsgemäß einzusetzenden Copolymerisaten einpolymerisierten Hydroxyalkyl-(meth)acrylat-Comonomeren liegt im Bereich von 15 bis 45 Gew.%, bezogen auf das Copolymerisat. Als zweite Gruppe von Comonomeren enthalten die erfindungsgemäß einzusetzenden Copolymerisate Acrylsäure und/oder Methacrylsäure in einer Menge von 5 bis 30 Gew.%, insbesondere in einer Menge von 10 bis 20 Gew.%, bezogen auf das Copolymerisat, einpolymerisiert. Als Beispiele für die Gruppe der Alkyl(meth)-acrylat-Comonomeren seien insbesondere die Acrylate und Methacrylate von geradkettigen oder verzweigten Monoalkanolen mit 1 bis 8 C-Atomen, vorzugsweise mit 1 bis 4 C-Atomen genannt. Der Anteil der Alkyl(meth)acrylat-Comonomereinheiten im Copolymerisat liegt im Bereich von 30 bis 80 Gew.%, vorzugsweise 40 bis 70 Gew.%, bezogen auf das Copolymerisat. Die Grenzen für den Anteil der einzelnen Comonomer-Gruppen in den Copolymerisaten sind im Hinblick auf deren allgemeine Eigenschaften und speziell der hiermit hergestellten, erfindungsgemäßen lichtempfindlichen Aufzeichnungselemente von Bedeutung.

Beispiele für Copolymerisate, die sich für den Einsatz als polymeres Bindemittel in den photopolymerisierbaren Aufzeichnungsschichten der erfindungsgemäßen lichtempfindlichen Aufzeichnungselemente als besonders vorteilhaft erwiesen haben, sind Hydroxypropylacrylat/Methacrylsäure/Methylmethacrylat-Copolymerisate, Hydroxypropylacrylat/Acrylsäure/Methylmethacrylat-Copolymerisate sowie Hydroxyethylmethacrylat)Methacrylsäure/Methylmethacrylat-Copolymerisate, die die Comonomeren in den vorstehend angegebenen Mengenverhältnissen einpolymerisiert enthalten.

Die erfindungsgemäß als polymeres Bindemittel einzusetzenden Copolymerisate können nach den an sich bekannten und üblichen Polymerisationsmethoden durch Copolymerisation der Comonomeren, beispielsweise in Lösung, hergestellt werden. Für die Lösungspolymerisation eignen sich beispielsweise niedere Alkanole, Ketone, Ester und ähnliche als Lösungsmittel. Als Polymerisationsinitiatoren kommen die üblichen radikalischen Starter, wie beispielsweise Azo-bis-isobutyronitril, Benzoylperoxid und dgl., in Betracht. Die Polymerisationstemperatur liegt im allgemeinen zwischen 50 und 100 °C.

In der photopolymerisierbaren Aufzeichnungsschicht der erfindungsgemäßen lichtempfindlichen Aufzeichnungselemente können ein oder mehrere Hydroxyalkyl-(meth)acrylat-Copolymerisate der in Rede stehenden Art als polymeres Bindemittel enthalten sein. Neben dem polymeren Bindemittel enthält die photopolymerisierbare Aufzeichnungsschicht im allgemeinen noch mindestens eine ethylenisch ungesättigte, photopolymerisierbare, niedermolekulare Verbindung, mindestens einen Photopolymerisationsinitiator bzw. ein Photopolymerisationsinitiatorsystem sowie gegebenenfalls weitere Zusatz- und/oder Hilfsstoffe zur Verbesserung bzw. Modifizierung der allgemeinen Eigenschaften der lichtempfindlichen Aufzeichnungselemente bzw. der hieraus hergestellten Druckformen oder Resistmuster.

Als ethylenisch ungesättigte, photopolymerisierbare niedermolekulare Verbindungen kommen sowohl Monomere als auch ethylenisch ungesättigte, photopolymerisierbare Oligomere mit einem Molekulargewicht bis etwa 5.000 in Betracht, wobei die photopolymerisierbaren niedermolekularen Verbindungen sowohl mono- als auch mehrfunktionell sein können, d.h. eine oder mehrere photopolymerisierbare, ethylenische Doppelbindungen besitzen können. Üblicherweise sind in der photopolymerisierbaren Aufzeichnungsschicht di- oder mehrfunktionelle ethylenisch ungesättigte, photopolymerisierbare niedermolekulare Verbindungen allein oder Mischungen hiervon mit einem untergeordneten Anteil an monofunktionellen ethylenisch ungesättigten, photopolymerisierbaren niedermolekularen Verbindungen enthalten. Als Vertreter für die ethylenisch ungesättigten, photopolymerisierbaren, niedermolekularen Verbindungen, die in der photopolymerisierbaren Aufzeichnungsschicht allein oder auch in Mischung miteinander enthalten sein können, seien insbesondere die Derivate der Acrylsäure und Methacrylsäure und hier vor allem die (Meth)acrylsäureester genannt. Beispiele hierfür sind die Di- und Tri-(meth)acrylate von Di- oder Polyolen wie Ethylenglykol, Diethylenglykol, Triethylenglykol, Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiole, Glycerin oder Pentaerythrit ; Pentaerythrittetra-(meth)acrylat, Glukosetri- oder -tetra(meth)acrylat ; ferner die Monoacrylate und Monomethacrylate der genannten Diole und Polyole, wie z. B. Ethylenglykol-, Di-, Tri- oder Tetraethylenglykolmono(meth)acrylat, Propandiol-mono(meth)acrylat und Butandiolmono(meth)acrylat, und die (Meth)acrylate von Monoalkanolen, insbesondere solche von Monoalkanolen mit 1 bis 20 C-Atomen. Ferner sind als ethylenisch ungesättigte, photopolymerisierbare niedermolekulare Verbindungen die monomeren und oligomeren Urethanacrylate und -methacrylate mit zwei oder mehr Acryloyl- und/oder Methacryloyl-Gruppen im Molekül zu nennen. Solche monomeren oder oligomeren Urethan-(meth)acrylate, die gegebenenfalls neben den Acryloyl- und/oder Methacryloyl-Gruppen auch noch freie Carboxylgruppen enthalten können, sind nach üblichen und an sich bekannten Verfahren erhältlich, beispielsweise durch Umsetzung von Diolen oder Polyolen der vorstehend genannten Art mit Di- oder Polyisocyanaten, beispielsweise Hexamethylendiisocyanat, Isophorondiisocyanat oder ähnlichen, unter Bildung eines Reaktionsprodukts mit freien Isocyanatgruppen und Umsetzung dieser Isocyanatgruppen mit beispielsweise Hydroxyalkyl(meth)acrylaten. Man kann auch zunächst die Hydroxyalkyl-(meth)acrylate mit den Di- oder Polyisocyanaten umsetzen und das resultierende ungesättigte Isocyanat anschließend mit der Diol- oder Polyolkomponente zur Reaktion bringen. Zur Einführung von freien Carboxyl-Gruppen in die Urethan-Verbindungen kann ein Teil der Hydroxylgruppen der Diol- bzw. vorzugsweise Polyol-Komponente mit mehrfachen Carbonsäuren bzw. insbesondere cyclischen Dicarbonsäureanhydriden unter Bildung der sauren Teilester der Carbonsäuren umgesetzt werden. Geeignete ethylenisch ungesättigte, photopolymerisierbare niedermolekulare Verbindungen für die erfindungsgemäßen lichtempfindlichen Aufzeichnungselemente sind auch die Acryloyl- und/oder Methacryloyl-Gruppen enthaltenden Verbindungen, wie sie erhalten werden durch Umsetzung von Acrylsäure und/oder Methacrylsäure mit Di- oder Polyepoxid-Verdindungen.

Neben den bevorzugt verwendeten Acrylaten und Methacrylaten, insbesondere der vorstehend genannten Art, seien als ethylenisch ungesättigte, photopolymerisierbare niedermolekulare Verbindungen auch die Allyl-Verbindungen und andere Vinyl-Verbindungen genannt, wie z. B. N-Vinylpyrrolidon, N-Vinylcaprolactam, Vinylacetat, Vinylpropionat, (Meth)acrylamid, N-Methylol-(meth) acrylamid, der Bisether des Ethylenglykols und des N-Methylol-(meth)acrylamids, Vinylcarbamate, Bisacrylamidoessigsäure und andere.

Die ethylenisch ungesättigten, photopolymerisierbaren niedermolekularen Verbindungen werden dabei - für den Fachmann selbstverständlich - so gewählt, daß sie mit den als polymeren Bindemitteln eingesetzten Hydroxyalkyl-(meth)acrylat-Copolymerisaten verträglich sind. Das Mengenverhältnis von polymerem Bindemittel zu den ethylenisch ungesättigten, photopolymerisierbaren niedermolekularen Verbindungen in der photopolymerisierbaren Aufzeichnungsschicht kann in weiten Grenzen, beispielsweise im Bereich von 5 : 95 bis 90 : 10 variiert werden und liegt im allgemeinen insbesondere im Bereich von 40 : 60 bis 90 : 10. Der Anteil der polymeren Bindemittel und ethylenisch ungesättigten, photopolymerisierbaren niedermolekularen Verbindungen in der photopolymerisierbaren Aufzeichnungsschicht richtet sich neben der Art dieser Verbindungen insbesondere nach dem gewünschten Eigenschaftsbild der lichtempfindlichen Aufzeichnungselemente bzw. der hieraus hergestellten Druckformen oder Resistmuster. Im allgemeinen wird dieses Verhältnis so gewählt, daß die photopolymerisierbare Aufzeichnungsschicht bei Raumtemperatur fest ist. Dies gilt insbesondere für den Einsatz der erfindungsgemäßen lichtempfindlichen Aufzeichnungsmaterialien als Photoresistfilm. Im übrigen sind die Kriterien für die Auswahl des Verhältnisses von polymerem Bindemittel zu ethylenisch ungesättigter, photopolymerisierbarer niedermolekularer Verbindung in Abhängigkeit von der Art dieser Verbindungen dem Fachmann geläufig.

Als Photopolymerisationsinitiatoren für die photopolymerisierbaren Aufzeichnungsschichten kommen die für lichtempfindliche, photopolymerisierbare Aufzeichnungsmaterialien üblichen und an sich bekannten Photoinitiatoren bzw. Photoinitiator-Systeme in Betracht. Beispielhaft seien hier genannt : Benzoin, Benzoinether, insbesondere Benzoinalkylether, substituierte Benzoine, Alkylether von substituierten Benzoinen, wie beispielsweise α-Methylbenzoinalkylether oder α-Hydroxymethylbenzoinalkylether ; Benzile, Benzilketale, insbesondere Benzildimethylketal, Benzilmethylethylketal oder Benzilmethylbenzylketal ; die als Photoinitiator wirksamen Acylphosphinoxid-Verbindungen, wie z. B. substituierte Benzoyl-diarylphosphinoxide ; Benzophenon, Derivate des Benzophenons, 4,4'-Dimethylaminobenzophenon, 4,4'-Diethylaminobenzophenon, Derivate von Michlers Keton ; Anthrachinon und substituierte Anthrachinone ; arylsubstituierte Imidazole oder deren Derivate, wie z. B. 2,4,5-Triarylimidazoldimere ; 2-Chlorthioxanthon und die als Photoinitiatoren wirksamen Acridin- oder Phenacin-Derivate. Beispiele für Initiatorsysteme sind Kombinationen der genannten Initiatoren mit Sensibilisierungshilfsmitteln oder Aktivatoren, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michlers Keton, oder Gemische aus 2,4,5-Triarylimidazoldimeren und 2-Mercaptobenzochinazol oder den Leukobasen von Triphenylmethanfarbstoffen. Die Auswahl der geeigneten Photoinitiatoren bzw. Photoinitiator-Systeme ist dem Fachmann geläufig. Die Photoinitiatoren bzw. Photoinitiator-Systeme sind in der photopolymerisierbaren Aufzeichnungsschicht im allgemeinen in Mengen von 0,001 bis 10 Gew.% insbesondere in Mengen von 0,05 bis 5 Gew.%, bezogen auf die photopolymerisierbare Aufzeichnungsschicht, enthalten.

Als weitere Zusatz- und/oder Hilfsstoffe, die in der photopolymerisierbaren Aufzeichnungsschicht der erfindungsgemäßen lichtempfindlichen Aufzeichnungselemente enthalten sein können, kommen z. B. thermische Polymerisationsinhibitoren, Farbstoffe und/oder Pigmente, photochrome Verbindungen bzw. Systeme, sensitometrische Regler, Weichmacher, Verlaufshilfsmittel, Füllstoffe, Verstärkungsmittel, Mattierungs- oder Gleitmittel und dgl. in Betracht. Geeignete thermische Polymerisationsinhibitoren sind z. B. Hydrochinon, Hydrochinon-Derivate, 2,6-Di-t.-butyl-p-kresol, Nitrophenole, N-Nitrosoamine, wie N-Nitrosodiphenylamin oder die Salze des N-Nitrosocyclohexylhydroxylamins. Beispiele für Farbstoffe und/oder Pigmente, die sowohl als Kontrastmittel als auch schichtverfestigend wirken können, sind unter anderem Brilliant Green Dye (C.I. 42 040), Victoria Reinblau FGA, Victoria Reinblau BO (C.I. 42 595), Malachitgrün, Kristallviolett, Victoria-Blau B (C.I. 44 045), Rhodamin-6 (C.I. 45 160), Naphthalimidfarbstoffe, Azosole und 3'-Phenyl-7-dimethylamino-2,2'-spiro-di-(2H-1-benzopyran). Photochrome Systeme, die bei Belichtung mit aktinischem Licht ihre Farbe reversibel oder irreversibel ändern, ohne hierbei den Photopolymerisationsprozeß zu stören, sind z. B. Leuko-Farbstoffe zusammen mit geeigneten Aktivatoren. Als Beispiele für Leuko-Farbstoffe seien die Leuko-Basen der Triphenylmethanfarbstoffe, wie Kristallviolett-Leukobase und Malachitgrün-Leukobase, Leuko-Basisch-Blau, Leuko-Pararosanilin, Leuko-Patentblau A und V genannt ; ferner kommt auch Rhodamin B-Base in Betracht. Als Aktivatoren für diese photochromen Verbindungen kommen unter anderem organische Halogenverbindungen, die bei Bestrahlung mit aktinischem Licht Halogenradikale abspalten, oder Hexaarylbisimidazole in Betracht. Zu den sensitometrischen Reglern gehören Verbindungen wie z. B. 9-Nitroanthracen, 10,10'-Bisanthron, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Als Weichmacher können die an sich bekannten und üblichen niedermolekularen oder hochmolekularen Ester, wie Phthalate oder Adipate, Toluolsulfonamid oder Tricresylphosphat, dienen. Die Zusatz- und/oder Hilfsstoffe sind in den photopolymerisierbaren Aufzeichnungsschichten in den für diese Zusatzstoffe üblichen und bekannten wirksamen Mengen vorhanden. Ihre Menge sollte jedoch im allgemeinen 30 Gew.%, vorzugsweise 20 Gew.%, bezogen auf die photopolymerisierbare Aufzeichnungsschicht, nicht überschreiten.

Das Mischungsverhältnis, in dem die einzelnen Komponenten in der photopolymerisierbaren Aufzeichnungsschicht vorhanden sind, wird im allgemeinen so gewählt, daß die Aufzeichnungsschicht nicht nur wäßrig-alkalisch entwickelbar, sondern vorteilhafterweise auch bei Raumtemperatur fest ist und gute Filmbildungseigenschaften besitzt. Für die Verwendung als Photoresistfilm wird die Zusammensetzung darüber hinaus so gewählt, daß die photopolymerisierbare Aufzeichnungsschicht gut laminierbar und unter Anwendung von Druck sowie gegebenenfalls Wärme auf ein Substrat übertragbar ist. Die Dicke der photopolymerisierbaren Aufzeichunugsschicht richtet sich bekanntermaßen nach dem Anwendungszweck der lichtempfindlichen Aufzeichnungselemente und kann dementsprechend in weiten Grenzen schwanken. Während sie für die Herstellung von Resistmustern im allgemeinen im Bereich von etwa 1 bis 50 μm liegt, kommen für die Herstellung von Hochdruckformen beispielsweise Schichtdicken von etwa 100 μm bis einigen mm in Betracht.

In einer typischen Ausführungsform der Erfin- dung besteht die photopolymerisierbare Aufzeich- nungsschicht der lichtempfindlichen Aufzeich- nungselemente aus einer homogenen, filmbilden- den und in wäßrig-alkalischen Entwicklerlösungen löslichen oder zumindest dispergierbaren Mischung von

a) 40 bis 90 Gew.% mindestens eines Hydroxyalkyl-(meth)acrylat-Copolymerisats der vorstehend genannten Art als polymerem Bindemittel,

b) 8 bis 55 Gew.% mindestens einer ethylenisch ungesättigten, photopolymerisierbaren niedermolekularen Verbindung mit 2 oder mehr polymerisierbaren Doppelbindungen oder Mischungen hiervon mit einem untergeordneten Anteil an ethylenisch ungesättigten, photopolymerisierbaren, niedermolekularen Verbindungen mit nur einer photopolymerisierbaren Doppelbindung, wobei die ethylenisch ungesättigten, photopolymerisierbaren niedermolekularen Verbindungen mit dem polymeren Bindemittel verträglich sein sollen,

c) 0,001 bis 10 Gew:% mindestens eines Photo- polymerisationsinitiators bzw. eines Photopoly- merisationsinitiator-Systems sowie

d) 0 bis 30 Gew.%, insbesondere 0,05 bis 20 Gew.%, an weiteren, die allgemeinen Eigenschaf- ten der lichtempfindlichen Aufzeichnungselemen- te bzw. der hieraus hergestellten Druckformen oder Resistmuster verbessernden bzw. modifizierenden Zusatz- und/oder Hilfsstoffen.

Als Träger für die photopolymerisierbaren Auf- zeichnungsschichten kommen die für lichtemp- findliche Aufzeichnungselemente der in Rede stehenden Art an sich bekannten und üblichen, dimensionsstabilen, starren oder vorzugsweise flexiblen Schichtträger in Betracht, wobei die Art des Schichtträgers vom Verwendungszweck der lichtempfindlichen Aufzeichnungselemente mitbestimmt wird. So kommen für die Herstellung von Druckplatten als dimensionsstabile Träger insbesondere Kunststoff-Filme oder -Folien, z. B. Polyesterfolien, sowie metallische Schichtträger, beispielsweise Stahl -oder Aluminiumbleche, in Betracht. Für Photoresistfilme und Schichtübertragungsmaterialen finden als Trägermaterialien vorzugsweise Kunststoff-Filme oder -Folien, z. B. Polyesterfolien, Verwendung, die eine mäßige Haftung zu der photopolymerisierbaren Aufzeichnungsschicht haben und nach dem Auflaminieren bzw. Aufkaschieren der photopolymerisierbaren Aufzeichnungsschicht auf ein Substrat von dieser - wahlweise vor oder nach der bildmäßigen Belichtung mit aktinischem Licht - abgezogen werden können. Für die Herstellung von Resistmu- stern kann die photopolymerisierbare Aufzeichu- nugsschicht auch direkt auf das zu schützende sowie gegebenenfalls dauerhaft zu modifizierende Substrat aufgebracht werden, welches dann als Schichtträger für die photopolymerisierbare Aufzeichnungsschicht dient. Als Substrate für Photoresistschichten kommen beispielsweise Kupferbleche, kupferkaschierte Basismaterialien, Keramiksubstrate, die mit metallischen oder me- talloxidischen Schichten beschichtet sind, Halb- leiterelemente, Silicium-Wafer und dgl. in Betracht. Die Trägermaterialien für die photopoly- risierbare Aufzeichnungsschicht können gege- nenfalls in an sich bekannter Weise, z. B. mechanisch, chemisch, elektrochemisch und/oder durch Versehen mit einer Haftgrundierung, vorbehandelt sein. Gleichermaßen können zwischen photopolymerisierbarer Aufzeichnungsschicht und Träger auch noch eine oder mehrere Zwischenschichten angeordnet sein, die bei lichtempfindlichen Aufzeichnungselementen für die Herstellung von Druckformen beispielsweise als Haftschichten und/oder Lichthofschutzschichten ausgebildet sein können.

Ebenso kann auf der dem Träger abgewandten Oberfläche der photopolymerisierbaren Aufzeichnungsschicht auch noch eine Deckschicht oder Deckfolie angeordnet sein, die vorzugsweise in der gleichen Entwicklerlösung löslich ist, wie die photopolymerisierbare Aufzeichnungsschicht, oder von dieser vor der Entwicklung abziehbar ist. Diese Deckschicht bzw. Deckfolie dient vor allem dem Schutz der photopolymerisierbaren Aufzeichnungsschicht bei der Lagerung und Handhabung der lichtempfindlichen Aufzeichnungsmaterialien und auch als Sauerstoffsperre für die photopolymerisierbare Aufzeichnungsschicht. Als besonders geeignet haben sich bei- spielsweise Deckschichten aus Polyvinylalkoho- len oder Polyvinylalkohol-Derivaten bzw., insbesondere für Photoresistfilme, Deckfolien aus Polyolefinen, z. B. Polyethylen oder Polypropylen, erwiesen.

Die Herstellung der erfindungsgemäßen lichtempfindlichen Aufzeichnungselemente kann in an sich bekannter und üblicher Weise durch Herstellung einer homogenen Mischung der die photopolymerisierbare Aufzeichnungsschicht bildenden Komponenten und schichtförmiges Aufbringen dieser Mischung auf den - gegebenenfalls mit einer Zwischenschicht versehenen - dimensionsstabilen Träger erfolgen. Vorteilhafterweise werden die lichtempfindlichen Aufzeichnungselemente hergestellt, indem man die Komponenten der photopolymerisierbaren Aufzeichnungsschicht in einem geeigneten Lösungsmittel bzw. Lösungsmittel-Gemisch löst und diese Lösung durch Gießen, Tauchen, Sprühen oder andere bekannte Auftragstechniken in der gewünschten Schichtstärke auf den Träger aufbringt. Anschließend wird das Lösungsmittel in üblicher Weise entfernt und die photopolymerisierbare Aufzeichnungsschicht getrocknet. Geeignete Lösungsmittel für das Mischen der Komponenten und Aufbringen der photopolymerisierbaren Aufzeichnungsschicht auf den Träger sind u.a. niedere Alkohole, Ketone oder Ester, wie z. B. Methanol, Aceton, Methylethylketon, Ethylcetat und ähnliche, sowie Mischungen hiervon.

Anschließend kann auf die photopolymerisierbare Aufzeichnungsschicht gewünschtenfalls noch die Deckschicht bzw. Deckfolie aufgebracht werden.

Die erfindungsgemäßen lichtempfindlichen Aufzeichnungselemente eignen sich in vorteilhafter Weise für die Herstellung von Druckformen oder Resistmustern nach den hierfür an sich bekannten und üblichen Verfahren. Hierzu wird die photopolymerisierbare Aufzeichnungsschicht - bei Photoresistfilmen und Schichtübertragungsmaterialien nach der Schichtübertragung auf das zu schützende Substrat - bildmäßig mit aktinischem Licht belichtet, wobei sich hierfür die üblichen Lichtquellen von aktinischem Licht, wie beispielsweise UV-Fluoreszenzröhren, Quecksilberhochmittel- oder -niederdruckstrahler, superaktinische Leuchtstoffröhren, Xenon-Impuls-Lampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein. Durch die bildmäßige Belichtung mit dem aktinischem Licht wird in den belichteten Bereichen der Aufzeichnungsschicht eine Photopolymerisation ausgelöst, die zu einer Vernetzung und damit Löslichkeitsdifferenzierung zwischen den belichteten und unbelichteten Schichtbereichen führt. Nach der bildmäßigen Belichtung wird die Druckform bzw. das Resistmuster durch Auswaschen der unbelichteten, unvernetzten Bereiche der Aufzeichnungsschicht mit einer wäßrig-alkalischen Entwicklerlösung entwickelt. Das Entwickeln kann durch Waschen, Sprühen, Abreiben oder Ausbürsten etc. erfolgen. Die erfindungsgemäßen Aufzeichnungselemente zeigen dabei einen großen Entwicklungsspielraum und eine sehr geringe Überwaschempfindlichkeit. Als Entwicklerlösungen kommen wäßrigalkalische Entwicklerlösungen in Betracht, die zur Einstellung des günstigsten pH-Wertes, im allgemeinen im Bereich von 8 bis 14, vorzugsweise im Bereich von 9 bis 12, alkalisch reagierende Substanzen, wie z. B. Borax, Dinatriumhydrogenphosphat, Soda, Alkalihydroxide oder organische Basen, wie Di- oder Triethanolamin, in Wasser gelöst enthalten. Die wäßrig-alkalischen Entwicklerlösungen können auch Puffersalze, z. B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z. B. Natriumcarboxymethylcellulose, Polyvinylalkohol, Polynatriumacrylat und dgl., mitverwendet werden. Obwohl die erfindungsgemäßen Aufzeichnungselemente im allgemeinen mit rein wäßrig-alkalischen Entwicklerlösungen ausgewaschen werden, ist es selbstverständlich grundsätzlich möglich, wenn auch nicht erforderlich, daß die wäßrig-alkalischen Entwicklerlösungen auch noch geringe Zusätze von wasserlöslichen, organischen Lösungsmitteln, wie z. B. aliphatischen Alkoholen, enthalten.

Die erfindungsgemäßen lichtempfindlichen Aufzeichnungselemente zeichnen sich durch ihre guten Belichtungseigenschaften und gute Entwickelbarkeit in wäßrig-alkalischen Entwicklerlösungen aus, wodurch es möglich ist, auch sehr feine Bildelemente vorlagengetreu und sicher zu reproduzieren. Auf metallischen oder metalloxidischen Untergründen besitzen die erfindungsgemäßen photopolymerisierbaren Aufzeichnungsschichten eine sehr gute Haftung, ohne daß es bei der Entwicklung der bildmäßig belichteten Aufzeichnungsschicht zur Ausbildung von Restschichtbelägen in den ausgewaschenen Bereichen kommt. Die erfindungsgemäßen lichtempfindlichen Aufzeichnungselemente eignen sich grundsätzlich für alle Anwendungsgebiete der Reprographie und der optischen Informationsfixierung, insbesondere zur Herstellung von Druckformen und Resistmustern.

Die Erfindung wird durch die nachfolgenden Beispiele näher erläutert. Die in den Beispielen genannten Teile und Prozente beziehen sich, sofern nicht anders angegeben, auf das Gewicht.

Beispiel 1

Eine homogene Mischung aus 70 Teilen eines Copolymerisats aus 20 % Hydroxypropylacrylat, 20 % Methacrylsäure und 60 % Methylmethacrylat, 40 Teilen Trimethylolpropantriacrylat, 4 Teile Benzophenon, 0,2 Teile Michlers Keton, 0,13 Teile Di-tert.-butyl-p-kresol, 0,6 Teile Kristallviolett-Leukobase, 3,8 Teile Hexachlorxylol, 6 Teile eines Polyester-Weichmachers und 0,05 Teile eines blauen Farbstoffs wurde in methanolischer Lösung auf ein kupferkaschiertes Basismaterial gegossen. Nach dem Ablüften des Lösungsmittels und Trocknen betrug die Dicke der so erhaltenen photopolymerisierbaren Schicht 35 µm. Zur Herstellung von Leiterbahnen wurde diese photopolymerisierbare Resistschicht durch eine photographische negative Bildvorlage mit aktinischem

## 0 194 440

Licht belichtet. Zur Entwicklung des Resistmusters wurden anschließend die unbelichteten Schichtanteile mit einer 1 %igen wäßrigen Sodalösung ausgewaschen. Die Entwicklung war problemlos. Das Resistmuster war auch in feinen Bildelementen vorlagengetreu und gut ausgebildet. Ein Restbelag auf dem Substrat in den ausgewaschenen Bereichen war nicht vorhanden. Die freigelegten Bereiche des Kupfers wurden durch galvanische Metallabscheidung dauerhaft modifiziert.

Beispiel 2

Es wurde wie in Beispiel 1 gearbeitet, diesmal jedoch anstelle des Copolymerisats von Beispiel 1 70 Teile eines Copolymerisates aus 20 % Hydroxypropylacrylat, 20 % Acrylsäure und 60 % Methylmethacrylat eingesetzt. Es wurden vergleichbare Ergebnisse wie in Beispiel 1 erhalten.

Beispiel 3

Es wurde eine homogene, photopolymerisierbare Mischung wie in Beispiel 1 hergestellt, jedoch wurden anstelle des dort verwendeten Copolymerisats diesmal 70 Teile eines Copolymerisats aus 40 % Hydroxyethylmethacrylat, 15 % Methacrylsäure und 45 % Methylmethacrylat verwendet. Bei entsprechender Arbeitsweise wie in Beispiel 1 wurde ein gut ausgeprägtes, in der Weiterverarbeitung stabiles Resistmuster hergestellt. Das Belichtungs- und Auswaschverhalten der Resistschicht waren ausgezeichnet.

**Patentansprüche**

1. Lichtempfindliches, zur Herstellung von Druckformen oder Resistmustern geeignetes Aufzeichnungselement mit einer auf einem dimensionsstabilen Träger aufgebrachten, wäßrig-alkalisch entwickelbaren, ein polymeres Bindemittel, mindestens eine ethylenisch ungesättigte, photopolymerisierbare niedermolekulare Verbindung, mindestens einen Photopolymerisationsinitiator bzw. ein Photopolymerisationsinitiatorsystem sowie gegebenenfalls weitere Zusatz- und/oder Hilfsstoffe enthaltenden, photopolymerisierbaren Aufzeichnungsschicht, dadurch gekennzeichnet, daß in der photopolymerisierbaren Aufzeichnungsschicht als polymeres Bindemittel mindestens ein in Wasser unlösliches, in wäßrig-alkalischen Lösungen jedoch lösliches oder zumindest dispergierbares, filmbildendes Copolymerisat aus 15 bis 45 Gew.% mindestens eines Hydroxyalkyl-(meth)acrylats, 5 bis 30 Gew.% Acrylsäure und/oder Methacrylsäure und 30 bis 80 Gew.% mindestens eines Alkylacrylats und/oder Alkylmethacrylats, wobei sich die Prozentangaben jeweils auf das Copolymerisat beziehen, enthalten ist.
2. Lichtempfindliches Aufzeichnungselement nach Anspruch 1, dadurch gekennzeichnet, daß die in der photopolymerisierbaren Aufzeichnungsschicht als polymeres Bindemittel enthaltenen Copolymerisate als Hydroxyalkyl-(meth)acrylate Monoacrylate und/oder Monomethacrylate von aliphatischen Diolen mit 2 bis 4 C-Atomen einpolymerisiert enthalten.

3. Lichtempfindliches Aufzeichnungselement nach einem der Ansprüche 1 oder 2, dadurch gekennzeichnet, daß die in der photopolymerisierbaren Aufzeichnungsschicht als polymeres Bindemittel enthaltenen Copolymerisate als Alkyl-(meth)acrylat-Comonomere Acrylate und/oder Methacrylate von Monoalkanolen mit 1 bis 4 C-Atomen einpolymerisiert enthalten.

4. Lichtempfindliches Aufzeichnungselement nach einem der Ansprüche 1 bis 3, dadurch gekennzeichnet, daß in der photopolymerisierbaren Aufzeichnungsschicht als polymeres Bindemittel ein Hydroxypropylacrylat/Methacrylsäure/Methylmethacrylat-Copolymerisat enthalten ist.

5. Lichtempfindliches Aufzeichnungselement nach einem der Ansprüche 1 bis 3, dadurch gekennzeichnet, daß in der lichtempfindlichen Aufzeichnungsschicht als polymeres Bindemittel ein Hydroxypropylacrylat/Acrylsäure/Methylmethacrylat-Copolymerisat enthalten ist.

6. Lichtempfindliches Aufzeichnungselement nach einem der Ansprüche 1 bis 3, dadurch gekennzeichnet, daß in der photopolymerisierbaren Aufzeichnungsschicht als polymeres Bindemittel ein Hydroxyethylmethacrylat/Methacrylsäure/Methylmethacrylat-Copolymerisat enthalten ist.

7. Lichtempfindliches Aufzeichnungselement nach einem der Ansprüche 1 bis 6, dadurch gekennzeichnet, daß die in der photopolymerisierbaren Aufzeichnungsschicht als polymere Bindemittel enthaltenen Copolymerisate 15 bis 45 Gew.% mindestens eines Hydroxyalkyl-(meth)acrylats, 10 bis 20 Gew.% Acrylsäure und/oder Methacrylsäure sowie 40 bis 70 Gew.% mindestens eines Alkyl(meth)acrylats einpolymerisiert enthalten, wobei sich die Prozentangaben jeweils auf das Copolymerisat beziehen.

8. Lichtempfindliches Aufzeichnungselement nach einem der Ansprüche 1 bis 7, dadurch gekennzeichnet, daß die photopolymerisierbare Aufzeichnungsschicht als ethylenisch ungesättigte, photopolymerisierbare niedermolekulare Verbindungen Monomere und/oder Oligomere mit zwei oder mehr Acryloyl- und/oder Methacryloyl-Gruppen enthält.

**Claims**

1. A light-sensitive recording element suitable for producing printing plates or resist patterns, comprising a dimensionally stable base material and applied thereon a photopolymerizable recording layer which is developable with an aqueous-alkaline solvent and contains a polymeric binder, at least one ethylenically unsaturated, photopolymerizable low molecular weight compound, at least one photopolymerisation initiator or photopolymerization initiator system and

8

optionally further additive and/or auxiliary substances, wherein the polymeric binder present in the photopolymerizable recording layer comprises at least one film-forming copolymer which is insoluble in water but soluble or at least dispersible in aqueous-alkaline solutions and prepared from 15-45 % by weight of at least one hydroxyalkyl (meth)acrylate, 5-30 % by weight of acrylic acid and/or methacrylic acid and 30-80 % by weight of at least one alkyl acrylate and/or alkyl methacrylate, the percentages all being based on the copolymer.

2. A light-sensitive recording element as claimed in claim 1, wherein the copolymers present as polymeric binder in the photopolymerizable recording layer contain as hydroxyalkyl (meth)acrylates monoacrylates and/or monomethacrylates of aliphatic diols of 2 to 4 carbon atoms as copolymerized units.

3. A light-sensitive recording element as claimed in claim 1 or 2, wherein the copolymers present as polymeric binder in the photopolymerizable recording layer contain as alkyl (meth)acrylate comonomers acrylates and/or methacrylates of monoalkanols of 1 to 4 carbon atoms as copolymerized units.

4. A light-sensitive recording element as claimed in any of claims 1 to 3, wherein the polymeric binder present in the photopolymerizable recording layer comprises a hydroxypropyl acrylate/methacrylic acid/methyl methacrylate copolymer.

5. A light-sensitive recording element as claimed in any of claims 1 to 3, wherein the polymeric binder present in the light-sensitive recording layer comprises a hydroxypropyl acrylate/acrylic acid/methyl methacrylate copolymer.

6. A light-sensitive recording element as claimed in any of claims 1 to 3, wherein the polymeric binder present in the photopolymerizable recording layer comprises a hydroxyethyl methacrylate/methacrylic acid/methyl methacrylate copolymer.

7. A light-sensitive recording element as claimed in any of claims 1 to 6, wherein the copolymers present as polymeric binder in the photopolymerizable recording layer contain from 15 to 45 % by weight of at least one hydroxyalkyl (meth)acrylate, from 10 to 20 % by weight of acrylic acid and/or methacrylic acid and from 40 to 70 % by weight of at least one alkyl (meth)acrylate as copolymerized units, the percentages all being based on the copolymer.

8. A light-sensitive recording element as claimed in any of claims 1 to 7, wherein the photopolymerizable recording layer contains as ethylenically unsaturated, photopolymerizable low molecular weight compounds monomers and/or oligomers having two or more acryloyl and/or methacryloyl groups.

**Revendications**

1. Elément d'enregistrement, sensible à la lumière, convenant à la fabrication de formes d'impression ou modèles réserve (résist), comportant, appliqué sur un support stable en dimension, une couche d'enregistrement photopolymérisable, développable par voie alcaline aqueuse et contenant un liant polymère, au moins un composé à bas poids moléculaire, au moins un initiateur ou système initiateur de photopolymérisation et éventuellement d'autres additifs et/ou auxiliaire, caractérisé par le fait que, dans la couche d'enregistrement photopolymérisable, est contenu, comme liant polymère, un copolymérisat filmogène, insoluble dans l'eau, mais soluble ou au moins dispersable dans des solutions alcalines aqueuses et constitué de 15 à 45 % en poids d'au moins un hydroxyalkyl(méth)acrylate, 5 à 30 % en poids d'acide acrylique et/ou acide méthacrylique et 30 à 80 % en poids d'au moins un alkylacrylate et/ou alkylméthacrylate, chacun des pourcentages se rapportant au copolymérisat.

2. Elément d'enregistrement, sensible à la lumière, selon la revendication 1, caractérisé par le fait que les copolymérisats contenus, comme liants polymères, dans la couche d'enregistrement photopolymérisable, contiennent, en polymérisation, comme hydroxyalkyl-(méth)acrylates, des monoacrylates et/ou monométhacrylates de diols aliphatiques à 2 à 4 atomes C.

3. Elément d'enregistrement, sensible à la lumière, selon l'une des revendications 1 ou 2, caractérisé par le fait que les copolymérisats contenus, comme liants polymères, dans la couche d'enregistrement photopolymérisable, contiennent, en polymérisation, comme comonomères d'alkyl-(méth)acrylate, des acrylates et/ou méthacrylates de monoalcanols ayant 1 à 4 atomes C.

4. Elément d'enregistrement, sensible à la lumière, selon l'une des revendications 1 à 3, caractérisé par le fait que dans la couche d'enregistrement photopolymérisable est contenu, comme liant polymère, un copolymérisat d'hydroxypropylacrylate/acide méthacrylique/méthylméthacrylate.

5. Elément d'enregistrement, sensible à la lumière, selon l'une des revendications 1 à 3, caractérisé par le fait que dans la couche d'enregistrement photopolymérisable est contenu, comme liant polymère, un copolymérisat d'hydroxypropylacrylate/acide acrylique/méthylméthacrylate.

6. Elément d'enregistrement, sensible à la lumière, selon l'une des revendications 1 à 3, caractérisé par le fait que dans la couche d'enregistrement photopolymérisable est contenu, comme liant polymère, un copolymérisat d'hydroxyéthylméthacrylate/acide méthacrylique/méthylméthacrylate.

7. Elément d'enregistrement, sensible à la lumière, selon l'une des revendications 1 à 6, caractérisé par le fait que les copolymérisats contenus, comme liants polymères, dans la couche d'enregistrement photopolymérisable, contiennent en polymérisation, 15 à 45 % en poids d'au moins un hydroxyalkyl-(méth)acrylate, 10 à 20 % en poids d'acide acrylique et/ou acide méthacrylique, ainsi que 40 à 70 % en poids d'au moins un alkyl(méth)acrylate, chacun des pourcentages se rapportant au copolymérisat.

8. Elément d'enregistrement, sensible à la lumière, selon l'une des revendications 1 à 7, caractérisé par le fait que la couche d'enregistrement photopolymérisable contient, comme composés à bas poids moléculaire, photopolymérisables, insaturés éthyléniquement, des monomères et/ou oligomères à deux ou plus de deux groupes acryloyle et/ou méthacryloyle.